# EUROPEAN PATENT APPLICATION

(11) **EP 3 487 274 A1**
(43) Date of publication of application: **22.05.2019**
(21) Application number: 17202643.7
(22) Date of filing: 20.11.2017
(51) Int. Cl.: H05K 9/00, H05K 1/14, G01S 7/481, G01S 17/89, H05K 1/02

(54) **ELECTRONIC DEVICE COMPRISING A STRUCTRAL PIECE WITH A CAGE POSITIONNED OVER AN ELECTRONIC COMPONENT**

(71) Applicant: Valeo Comfort and Driving Assistance, 94046 Créteil Cedex (FR)
(72) Inventor: BEAUDOIN, Sylvain, 94046 Créteil CEDEX (FR); CARNEIRO, Florian, 94046 Créteil (FR); DURIEZ, Vincent, 94046 Créteil CEDEX (FR); FERNANDEZ-LOPEZ, Priscila, 94046 Créteil (FR); FRIC, Miroslav, 10800 Praha 10 - Stra nice (CZ); GRATZL, Peter, 94046 Créteil (FR); KRUPKA, Ales, 10800 Praha 10 - Stra nice (CZ); LAFON, Frederic, 94046 Créteil (FR); MORVAN, Guillaume, 94046 Créteil CEDEX (FR)
(74) Representative: Delplanque, Arnaud

(57) **Abstract**

The present invention relates to an electronic device (1) comprising at least one electrically conductive structural piece (10) and an electronic printed card (12) with at least one electronic component (120) emitting an electromagnetic radiation (W), wherein said at least one structural piece (10) comprises walls (100a) forming a cage (100) located inside the external periphery (100b) of said at least one structural piece (10), said walls (100a) extending towards said electronic printed card (12) and said cage (100) being adapted to be positioned over said at least one electronic component (120), said cage (100) forming a one-piece with said at least one structural piece (10).

## Description

### FIELD OF THE INVENTION

The present invention relates to an electronic device comprising at least one electrically conductive structural piece and an electronic printed card located with at least one electronic component emitting an electromagnetic radiation. Such an electronic device may be used, but not exclusively, in a motor vehicle.

### BACKGROUND OF THE INVENTION

An electronic device comprising at least one electrically conductive structural piece and an electronic printed card, well-known by the man skilled in the art, can be found in a motor vehicle, and is used for a time of flight technology referred as TOF. The time of flight technology permits a distance measurement of the objects in the environment of the motor vehicle. Said electronic device comprises at least one electronic component disposed on said electronic printed card, which emits an electromagnetic radiation.

One problem of this prior art is to fulfill the electromagnetic compatibility, known as EMC, so as said electromagnetic radiation doesn't affect the other electronic devices of said motor vehicle.

### SUMMARY OF THE INVENTION

It is an object of the invention to provide an electronic device comprising at least one electrically conductive structural piece and an electronic printed card located with at least one electronic component emitting an electromagnetic radiation, which resolves the problem above-stated.

To this end, there is provided an electronic device comprising at least one electrically conductive structural piece and an electronic printed card with at least one electronic component emitting an electromagnetic radiation, wherein said at least one structural piece comprises walls forming a cage located inside the external periphery of said at least one structural piece, said walls extending towards said electronic printed card and said cage being adapted to be positioned over said at least one electronic component, said cage forming a one-piece with said at least one structural piece.

As we will see in further details, the cage is acted as a faraday cage so that the electromagnetic radiation emitted by the at least one electronic component is confined within said cage and can't interfere with other electronic devices of said motor vehicle. Furthermore, as said cage forms a one-piece with said structural piece, i.e. there is only one monobloc unit, it reduces the time assembly of said electronic device.

Said walls extend towards said electronic printed card. In particular, it extends in parallel to the longitudinal axe of the assembly of the electronic device. It permits to have some contact surfaces with a ground trace of said electronic printed card. The length of the walls is adapted according to the space available between the structural piece and the electronic printed card. The length of the walls is adapted according to the height of the electronic component. The structural piece is positioned remotely from the electronic printed card at least level with said electronic component. Hence, there is a space between said structural piece and said electronic printed card in order to make some room for the electronic component.

In a non-limitative embodiment, said at least one structural piece is a cover and/or a receptacle of a housing of said electronic device and/or an intermediate frame of said electronic device.

In a non-limitative embodiment, said electronic printed card is sandwiched between said cover and said receptacle.

In a non-limitative embodiment, said cage is molded with said at least one structural piece or is stamped within said at least one structural piece.

In a non-limitative embodiment, said at least one electronic component is an active electronic component.

In a non-limitative embodiment, said electronic printed card comprises a ground trace, and said ground trace is adapted to surround said at least one electronic component.

In a non-limitative embodiment, said electronic printed card comprises a ground trace, and free ends of walls of said structural piece comprise at least one contact surface with said ground trace.

In a non-limitative embodiment, said electronic printed card comprises a plurality of electronic components which are arranged on said electronic printed card so as to limit the current path.

In a non-limitative embodiment, said plurality of electronic components is arranged on said electronic printed card so as to create opposite current directions. It permits to limit the current path.

In a non-limitative embodiment, said electronic device further comprises a light transmitter comprising at least one light source, and a light receiver.

In a non-limitative embodiment, said intermediate frame is adapted to support a lens of said light receiver.

In a non-limitative embodiment, said at least one structural piece further comprises an opening through which a lens of said light receiver is adapted to be inserted.

In a non-limitative embodiment, said intermediate frame is sandwiched between said electronic printed card and said receptacle.

In a non-limitative embodiment, said electronic device further comprises another electronic printed card comprising a video sensor.

In a non-limitative embodiment, said other electronic printed card is disposed at the bottom of said receptacle.

In a non-limitative embodiment, said electronic device is a TOF camera.

The invention also relates to a TOF camera which comprises:
- a housing with a cover and a receptacle;
- an electronic printed card with at least one electronic component; wherein said electronic printed card is sandwiched between said cover and said receptacle.

In a non-limitative embodiment, said TOF camera further comprises a light transmitter comprising at least one light source, and a light receiver.

In a non-limitative embodiment, said cover and said electronic printed device comprise an opening through which a lens of said light receiver is adapted to be inserted.

In a non-limitative embodiment, said electronic device further comprises an intermediate frame adapted to support a lens of said light receiver.

In a non-limitative embodiment, said intermediate frame is sandwiched between said electronic printed card and said receptacle.

In a non-limitative embodiment, said electronic device further comprises another electronic printed card comprising a video sensor.

In a non-limitative embodiment, said other electronic printed card is disposed at the bottom of said receptacle.

### BRIEF DESCRIPTION OF THE FIGURES

Some embodiments of methods and/or apparatus in accordance with embodiments of the present invention are now described, by way of example only, and with reference to the accompanying drawings, in which:
- Fig. 1 schematically depicts an electronic device comprising at least one electrically conductive structural piece with a cage, and one electronic printed card, according to a first non-limitative embodiment of the invention;
- Fig. 2 schematically depicts said electronic device of Fig. 1, said electronic device further comprises an intermediate frame, according to a non-limitative embodiment;
- Fig. 3 schematically depicts a ground trace of said electronic printed card of said electronic device of Fig. 1 and Fig. 2, according to a non-limitative embodiment;
- Fig. 4 is a schematic view from below of the cover of a housing of said electronic device of Fig. 1 and Fig. 2;
- Fig. 5 schematically depicts an electronic device comprising two electrically conductive structural pieces with a cage, and one electronic printed card, according to a second non-limitative embodiment of the invention; and
- Fig. 6 schematically depicts an electronic device comprising two electrically conductive structural pieces with a cage, and one electronic printed card, according to a third non-limitative embodiment of the invention.

### DESCRIPTION OF EMBODIMENTS OF THE INVENTION

In the following description, well-known functions or constructions by the man skilled in the art are not described in detail since they would obscure the invention in unnecessary detail.

The present invention relates to an electronic device 1.

In a non-limitative embodiment, said electronic device 1 is adapted to be disposed in a motor vehicle. In a non-limitative variant of said embodiment, said electronic device 1 is adapted to be disposed in the motor vehicle in-cabin.

Said embodiment is taken as a non-limitative example in the following description.

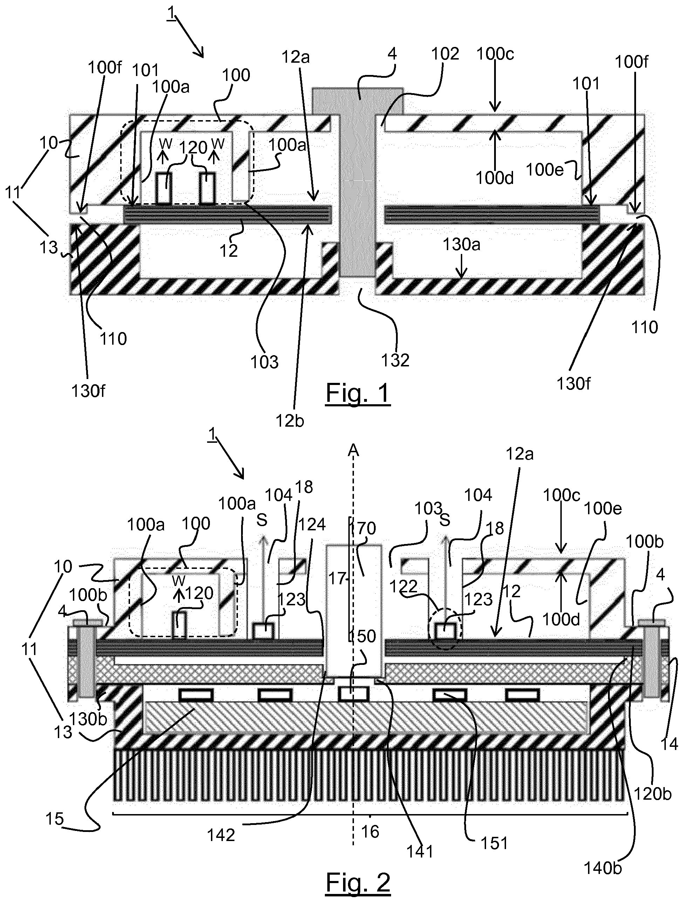

Such an electronic device 1 is illustrated in Fig.1 to Fig. 6.

It comprises:
- at least one electrically conductive structural piece 10, 13, 14;
- an electronic printed card 12 with at least one electronic component 120.

Said electrically conductive structural piece 10, 13, 14 is also called structural piece 10, 13, 14 in the following.

Said at least one electronic component 120 emits an electromagnetic radiation W. It is an active electronic component 120.

In a non-limitative embodiment, said at least one electrically conductive structural piece 10, 13, 14 is in a conductive material which is of aluminum.. In another non-limitative embodiment, said conductive material is an electrically charged plastic.

In a non-limitative embodiment, said electronic device 1 is a 3D-camera. In a non-limitative variant of said embodiment, said 3D camera is a TOF ("Time Of Flight Technology") camera.

In a non-limitative embodiment, said electronic device 1 further comprises one light transmitter 122 with at least one light source 123. In a non-limitative variant, said light transmitter 122 comprises a plurality of light sources 123.

In a non-limitative embodiment illustrated in Fig. 2, said electronic device 1 further comprises one light receiver 17.

The components of said electronic device 1 are further described hereinafter.

### • Structural piece 10, 13, 14

As illustrated in Fig. 1, Fig. 5, Fig. 6 and Fig. 2, in a non-limitative embodiment, the electronic device 1 comprises a housing 11 with a cover 10 and a receptacle 13.

In non-limitative embodiments, said structural piece 10, 13, 14 is the cover and/or the receptacle 13 of said housing 11 of said electronic device 1 and/or an intermediate frame 14 of said electronic device 1.

Said at least one structural piece 10, 13, 14 comprises walls 100a forming a cage 100 located inside the external periphery 100b, 130b, 140b of said at least one structural piece 10, 13, 14, said walls 100a extending towards said electronic printed card 12 and said cage 100 being adapted to be positioned over said at least one electronic component 120, said cage 100 forming a one-piece with said at least one structural piece 10, 13, 14.

Said walls 100a extend towards said electronic printed card 12. In particular, it extends in parallel to the longitudinal axe A illustrated in Fig. 2 of the assembly of the electronic device 1. It permits to have some contact surfaces 101 with a ground trace 121 of said electronic printed card 12.

The length of the walls 100a is adapted according to the space available between the structural piece 10, 13, 14 and the electronic printed card 12. The length of the walls 100a is adapted according to the height of the electronic component 120.

The structural piece 10, 13, 14 is positioned remotely from the electronic printed card 12 at least level with said electronic component 120. Hence, there is a space between said structural piece 10, 13, 14 and said electronic printed card 12 in order to make some room for the electronic component 120.

The cover 10 and the receptacle 13 of the housing 11, and the intermediate frame 14 are described below.

### o Cover 10

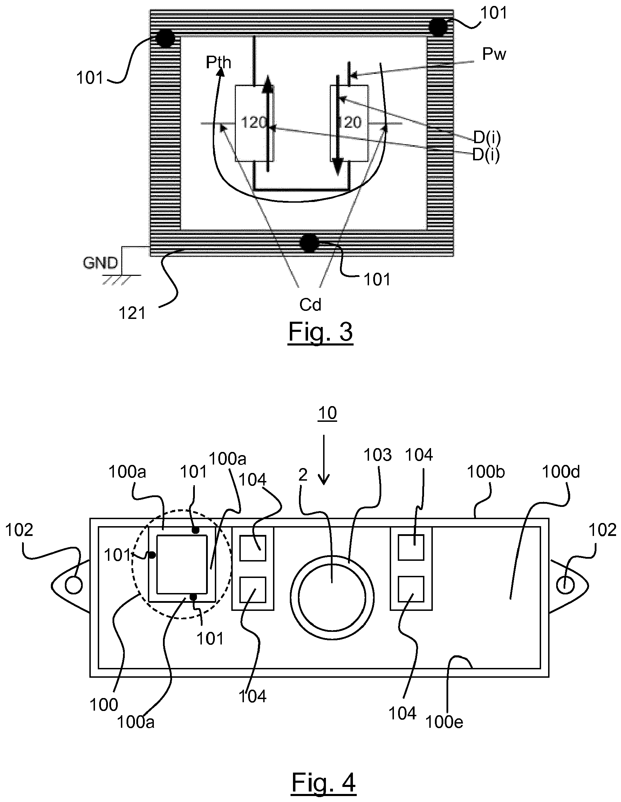

The cover 10 is illustrated in Fig. 1, Fig. 2, and Fig. 4 to Fig. 6. The Fig. 4 is a view of below of the cover 10.

Said cover 10 comprises an outer face 100c and an inner face 100d. As illustrated in Fig. 1, Fig. 2, Fig. 5 and Fig. 6, said inner face 100d is facing the electronic printed card 12.

As illustrated in Fig. 1, Fig. 2, Fig. 4 to Fig. 6, said cover 10 comprises walls 100a forming a cage 100 located inside its external periphery 100b. In a non-limitative example illustrated in Fig. 4, it comprises four walls 100a. In other non-limitative examples not illustrated, it comprises less or more than four walls 100a.

In a non-limitative embodiment illustrated in Fig. 1, and Fig. 4 to Fig. 6, one wall 100a is formed by a part of the inner periphery 100e of said cover 10 and two other walls 100a are different from said inner periphery 100e. In another non-limitative embodiment not illustrated, all the walls 100a are different from the inner periphery 100e.

Said cage 100 is adapted to be positioned over said at least one electronic component 120. It permits to confine said at least one electronic component 120 within said cage 100. Hence, it limits the electromagnetic radiation leakage of said at least one electronic component 120 so as to reduce the interference of said electromagnetic radiation with other electronic devices of said motor vehicle, such as in non-limitative examples a radio, a navigation system etc. Hence, said cage 100 forms an electromagnetic shielding protection for said at least one electronic component 120.

Said cage 100 forms a one-piece with said cover 10. In other words, it is formed integrally with said upper cover 10 so as said cage 100 and said upper cover 10 form a monobloc unit. Hence, said cage 100 comes from the material of said upper cover 10. It permits to simplify the processing assembly of said electronic device 1 and to reduce the time assembly compared to a cage 100 which would be detachable from said cover 10 for example.

In a first non-limitative embodiment, said cage 100 is molded with said cover 10. In a non-limitative variant of said first embodiment, said cage 100 is obtained by die-casting said cover 10.

In a second non-limitative embodiment, said cage 100 is stamped within said cover 10.

The cover 10 is adapted to be assembled with said receptacle 13 so as to close said housing 11. In a non-limitative embodiment, the assembly is performed via fixing means 4. In a non-limitative embodiment, the fixing means 4 are two screws. As illustrated in Fig. 2 and Fig. 4, in this case, in a non-limitative embodiment, the cover 10 and the receptacle 13 respectively comprise two holes 102, 132 to receive said screws 4. The holes 102, 132 are distributed on both sides of the cover 10 and the receptacle 13.

The holes 102, 132 may be a source of electromagnetic radiation leakage and thus electromagnetic interference. But, thanks to the cage 100, the electromagnetic radiation leakage of said electronic component(s) 120 through said holes 102, 132 is reduced.

As illustrated in Fig. 1, Fig. 5 and Fig. 6, said cover 10 comprises an edge 100f. Said electronic device 1 comprises a gap 110 between said cover 10 and said receptacle 13 partly all along the edge 100f of said cover 10 and the edge 130f of said receptacle 13. Said gap 110 permits to take into account the manufacturing tolerance so as to permit the sandwich assembly of said cover 10, said receptacle 13 and said electronic printed card 12. It is to be noted that said gap 110 may be a source of electromagnetic radiation leakage and thus of electromagnetic interferences. The longer the gap 110 is, the greater the electromagnetic radiation leakage is. But, thanks to the cage 100, the electromagnetic radiation leakage of said electronic component(s) 120 through said gap 110 is reduced.

As illustrated in Fig. 1, Fig. 2 to Fig. 6, in a non-limitative embodiment, the free end walls 100a of said cover 10 comprises at least one contact surface 101 with said electronic printed card 12. In particular, said cover 10 further comprises at least one contact surface 101 with a ground trace 121 of said electronic printed card 12. Hence, the cover 10 is electrically connected to the ground Gnd. Hence, the cage 100 of said cover 10 forms a Faraday cage which prevents electromagnetic radiation leakage. As illustrated in Fig. 3 and Fig. 4, in a non-limitative variant of said embodiment, the free end walls 100a of said cover 10 comprises three contact surfaces 101 with said ground trace 121. The three contact surfaces 101 permits to have a good connection and a balanced support on said ground trace 121.

As illustrated in Fig. 1, Fig. 2, and Fig. 4 to Fig. 6, there is a free end wall 100a of said cover 10 where said cover 10 is not in contact with said electronic printed card 12 so as to obtain a pathway 103 (illustrated in Fig. 1) for electrical to the routing of the at least one electronic component 120. Said wall 100a has therefore a lower height than the other walls 100a.

As illustrated in Fig. 2 and Fig. 4, in a non-limitative embodiment, said cover 10 further comprises an opening 103 through which the light receiver 17 is adapted to be inserted. In a non-limitative embodiment, said opening 103 is centered within said cover 10.

Said opening 103 may be a source of electromagnetic radiation leakage. But, thanks to the cage 100, the electromagnetic radiation of said electronic component(s) 120 through said opening 103 is reduced.

In a non-limitative embodiment, said light receiver 17 is placed within the motor vehicle in-cabin. In a non-limitative example, it is placed in the dashboard of the motor vehicle.

As illustrated in Fig. 2 and Fig. 4, in a non-limitative embodiment, said cover 10 further comprises at least one opening 104 for one light source 123 through which a transmitted modulated light signal S of said light source 123 may go through. In the non-limitative examples illustrated, there are four openings 104, one for each light source 123. Said opening 104 may be a source of electromagnetic radiation leakage. But, thanks to the cage 100, the electromagnetic radiation of said electronic component(s) 120 through said opening 104 is reduced.

### o Receptacle 13

The receptacle 13 is illustrated in Fig. 1, Fig. 2, and Fig. 4 to Fig. 6.

The receptacle 13 is adapted to apply with said cover 10 a pressure on said electronic printed card 12.

The receptacle 13 comprises an edge 130f which is disposed opposite to the edge 100f of the upper cover 10, and the gap 110 described above extends partly all along the edge 130f.

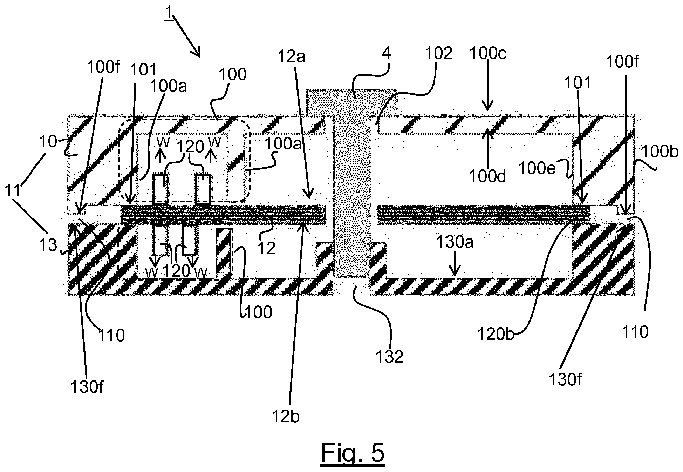

In a non-limitative embodiment illustrated in Fig. 5, said receptacle 13 is a structural piece comprising walls 100 forming a cage 100 located inside the external periphery 130b of said at least one structural piece 13. Said cage 100 is adapted to be positioned over said at least one electronic component 120 and said cage 100 forms a one-piece with said receptacle 13.

The above description of the structural piece with a cage 100 which is the cover 10 is also applied to the structural piece with a cage 100 which is the receptacle 13.

### o Intermediate frame 14

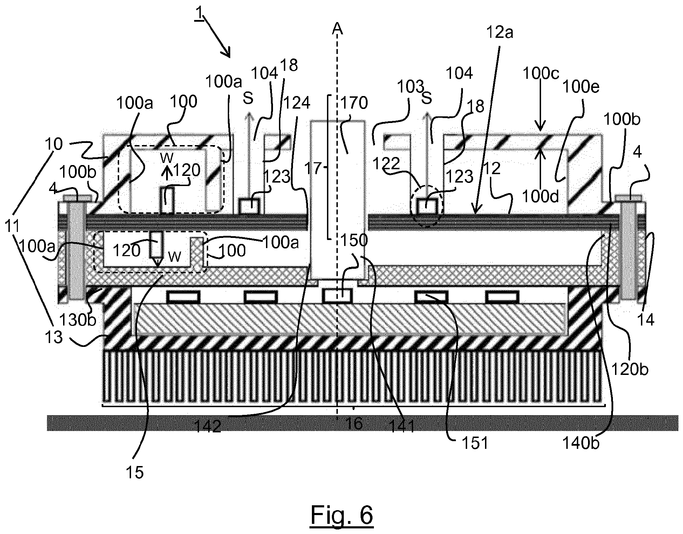

As illustrated in Fig. 2 and Fig. 6, in a non-limitative embodiment, the electronic device 1 further comprises an intermediate frame 14 located inside said housing 11 and which is adapted to support the light receiver 17.

In a non-limitative embodiment, the intermediate frame 14 comprises an opening 142 through which the lens 170 of the light receiver 17 is adapted to be inserted.

As illustrated, the lens 170 goes through the intermediate frame 14, the electronic printed card 12 and the cover 10 so that it may receive part of the reflected light signal of the light source(s) 123.

The intermediate frame 14 comprises a support 141 on which rests the lens 170. In a non-limitative embodiment, the lens 170 is glued on said support 141.

The intermediate frame 14 comprises a face which is facing the electronic printed card 12.

In a non-limitative embodiment, said intermediate frame 14 is sandwiched between said electronic printed card 12 and said receptacle 13 of said housing 11.

In other words, said electronic printed card 12 and said receptacle 13 apply a pressure on said electronic printed card 12. The pressure is applied via a gripping force. In a non-limitative embodiment, said gripping force is exerted via the fixing means 4.The pressure is applied on the periphery 140b of said intermediate frame 14. Hence the intermediate frame 14 is sandwiched on its periphery 140b between said electronic printed card 12 and said receptacle 13.

Hence, the fixing means 4 permit to assemble the intermediate frame 14 with the other components 10, 12 and 13 of the electronic device 1.

In a non-limitative embodiment illustrated in Fig. 6, if some electronic components 120 are disposed on the face 12b of the electronic printed card 12, when the electronic device 1 comprises an intermediate frame 14, one structural piece with the cage 100 may also be the intermediate frame 14. Hence, the above description of the structural piece with a cage 100 which is the cover 10 is also applied to the structural piece with a cage 100 which is the intermediate frame 14.

Hence, in the case of the electronic device architecture of Fig. 2, and in the case the electronic components 120 are disposed on one or two faces of the electronic printed card 12, one may have one or two structural pieces with a cage: the cover 10 and/or the intermediate frame 14.

### • Electronic printed card 12

As illustrated in Fig. 1, Fig. 2 and Fig. 6, in a non-limitative embodiment, the electronic printed card 12 is sandwiched between said cover 10 and said receptacle 13.

In other words, said cover 10 and said receptacle 13 apply a pressure on said electronic printed card 12. The pressure is applied via a gripping force. In a non-limitative embodiment, said gripping force is exerted via some fixing means 4. The pressure is applied on the periphery of said electronic printed card 12. Hence the electronic printed card 12 is sandwiched on its periphery 120b between said electronic printed card 12 and said receptacle 13.

The fixing means 4 are adapted to assemble all the components of the electronic device 1 together. Hence, in the non-limitative example of the screws 4, said screws 4 are adapted to go through said cover 10, said electronic printed card 12 and said receptacle 13.

The electronic printed card 12 comprises two faces 12a and 12b which are opposed.

As illustrated in Figure 3, the electronic printed card 12 further comprises a ground trace 121 which is connected to the ground Gnd.

The electronic printed card 12 is in contact on one face 12a with said cover 10 via its ground trace 121 and it is in contact on the other face 12b with said receptacle 13 along the edge 130f of said receptacle 13.

In a non-limitative embodiment, said electronic printed card 12 is a printed circuit board assembly PCBA.

In a non-limitative embodiment, the electronic printed card 12 comprises a plurality of electronic components 120. In non-limitative embodiments, said plurality of electronic components 120 are disposed on one face 12a or 12b, or on the two faces 12a and 12b.

In a first non-limitative embodiment illustrated in Fig. 1 and Fig. 2, the electronic printed card 12 comprises a plurality of electronic components 120 which are disposed on a unique face 12a. In this case, in a first non-limitative embodiment, there is only one structural piece with a cage 100: the cover 10 which comprises the cage 100.

In a second non-limitative embodiment illustrated in Fig. 5, the electronic printed card 12 comprises a plurality of electronic components 120 which are disposed on two faces 12a and 12b. In this case, in a second non-limitative embodiment, there are two structural pieces with a cage 100: the cover 10 which comprises a cage 100 to cover the electronic components 120 on the face 12a, and the receptacle 13 which comprises a cage 100 to cover the electronic components 120 on the face 12b.

In a third non-limitative embodiment illustrated in Fig. 6, the electronic printed card 12 comprises a plurality of electronic components 120 which are disposed on two faces 12a and 12b, and there is an intermediate frame 14 as described before. In this case, in a third non-limitative embodiment, there are two structural pieces with a cage 100: the cover 10 which comprises a cage 100 to cover the electronic components 120 on the face 12a, and the intermediate frame 14 which comprises a cage 100 to cover the electronic components 120 on the face 12b.

In a non-limitative embodiment, said at least one electronic component 120 which is encased within said cage 100 is a switch. The switch is adapted to control the current i of at least one light source 123 of the light transmitter 122. Hence, in a non-limitative embodiment, said switch 120 is part of a driver for said at least one light source 123.

In the following description, said switch is taken as a non-limitative example. In a non-limitative embodiment, one switch 120 is associated to one light source 123. Therefore, one switch 120 is adapted to control the current i of only one light source 123.

In a non-limitative embodiment, said switch 120 is a transistor. In a non-limitative example, said transistor is a MOSFET.

Said switch 120 is adapted to control the current i of a light source 123 so as to modulate a light signal generated by said light source 123 so as to obtain a modulated light signal S.

The switch 120 is adapted to switch at a frequency which fulfills the frequency of the modulated light signal S.

In a non-limitative embodiment, the switch 120 switches at around a 25-30 MHz frequency. It is the frequency which drives the current i of a light source 123, when said light source 123 is an IR LED.

It is to be noted that the switch 120 doesn't generate a high heat because it doesn't stay in an on-state very long; so there is no necessary to address a heating dissipation problem for said switch 120.

As illustrated in Fig. 3, the switch 120 is connected to the ground Gnd. In particular the switch 120 is connected to the ground trace 121 of said electronic printed card 12.

As illustrated in Fig. 3, in a non-limitative embodiment, the ground trace 121 is adapted to surround the switch(s) 120 which is encased within said cage 100. It permits to confine the electromagnetic radiation of the switch(s) 120 inside the periphery of said ground trace 121.

Furthermore, as illustrated in Fig. 3, in a non-limitative embodiment, when there is a plurality of switches 120, said plurality of switches 120 are arranged on said electronic printed card 12 so as to limit the current path Pth In the non-limitative example of two switches 120, the current path Pth is limited by placing the switch 120 in manner to have the current flowing in one direction in the first switch 120 and in the other direction in the second switch 120, so as to reduce the electromagnetic fields coming from both switches 120. Indeed, in this arrangement, the electromagnetic fields radiated by each switch 120 cancel each other.

Hence, plurality of switches 120 are arranged on said electronic printed card 12 so as to create opposite current directions D(i) as illustrated in Fig. 3 to limit the current path. The opposite current directions D(i) are illustrated by the two opposite arrows. Hence, in the non-limitative example illustrated in Fig. 3, one current in the switch 120 goes in an opposite direction D(i) to the current in the other switch 120. The reference Pw illustrates the power supply (to supply the switches 120) coming from another layer of the electronic printed card 12, and the reference Cd illustrates the command signals (to command the switches 120) coming from another layer of the electronic printed card 12.

It is to be noted that when the plurality of switches 120 are routed so as to create a current path which is almost straight, said switches 120 form a dipole which generates a higher electromagnetic field. As this routing permit to obtain a localized electromagnetic radiation W, the switches 120 will be shielded by the cage 100.

As illustrated in Fig. 3, in a non-limitative embodiment, said electronic printed card 12 further comprises an opening 124 through which a lens 170 of the light receiver 17 is adapted to be inserted.

### • Light transmitter 122 and light receiver 17

The light transmitter 122 is illustrated in Fig. 1 and Fig. 2.

The light receiver 17 is illustrated in Fig. 2.

In a non-limitative embodiment, said light transmitter 122 comprises a plurality of light sources 123. In a non-limitative embodiment of said variant, a light source 123 is an infrared light emitting diode also referred as IR LED.

In a non-limitative example illustrated in Fig. 1, said light transmitter 122 comprises four light sources 123.

As illustrated in Fig. 2, in a non-limitative embodiment, the light transmitter 122 is disposed on said electronic printed card 12. The light source(s) 123 is disposed on the face 12a of said electronic printed card 12 so as to permit its emitted modulated light signal S (illustrated in Fig. 2 and described later in the description) to be directed outside the housing 11 of said electronic device 1.

The light receiver 17 comprises a lens 170 and the video sensor 150.

In a non-limitative embodiment, the electronic device 1 further comprises at a reflector 18 illustrated in Fig. 2 which is adapted to be coupled with a light source 123.

When the cover 10 is made of aluminum, it permits a good heat dissipation of the heat of the light source(s) 123.

The heat generated by the light source(s) 123 of the light transmitter 122 is dissipated by the cover 10 thanks to said reflector 18. Said reflector 18 surrounds said light transmitter 122 and permits to increase the illumination angle of the modulated light signal S of the light source(s) 123. As illustrated in Fig. 2, said reflector 18 is in contact with the edge of opening 104 of the cover 10, and is connected to the electronic printed card 12 with thermal paste (not illustrated). In a non-limitative embodiment, said reflector 18 is plasticized chrome. The electromagnetic leakage of the switch 120 goes through said reflector 18. But, thanks to the cage 100, the electromagnetic radiation leakage of said electronic component(s) 120 through said reflector 18 and thus said opening(s) 104 is reduced.

The light transmitter 122 is adapted to transmit a modulated light signal S illustrated in Fig. 2 so as to illuminate a scene. The transmitted modulated light signal S bounces off objects in the scene which creates a reflected light signal. Part of the reflected light signal comes back to the light receiver 17 and therefore corresponds to a received modulated light signal. The round-trip time from the light transmitter 122 to the light receiver 17 is an indicator of a distance. Hence, a distance can be measured. Such a distance measurement is part of a time of flight technology which is well-known by the man skilled in the art.

As the transmitted modulated light signal S is periodic, the phase difference between the transmitted modulated light signal S and the received modulated light signal is an indicator of the round-trip time. Knowing the round-trip time one can deduce the distance between the light receiver 17and an object within the scene.

The frequency of the transmitted modulated light signal S which drives the light source 123 is a trade-off between the internal characteristic of the light source 123 and the maximum distance that one wants to measure.

Indeed, when the light source 123 is an IR LED, IR LEDs have a parasitic capacitance which impacts the rising time of the modulated light signal S. With IR LEDs the frequency is limited around 30MHz.

On the contrary the maximum distance is proportionally inverted to the frequency. More the frequency is high more the maximum distance is short. For example with a frequency of 30 MHz one can measure a distance of 6m. For motor vehicle in-cabin application, ideally the maximum distance would be around 1,5m (modulated frequency lower than 30MHz). Said maximum distance is the maximum distance which can be calculated between the light receiver 17 of the camera 1 and an object within the scene which is within the motor vehicle in-cabin. In the motor vehicle in-cabin, the distance between the passengers or conductor and the light receiver 17 of the camera 1 is around 1,5m.

In addition to the high frequency, one needs to drive the IR LEDs with a high current i (around 3A) in order to illuminate the scene efficiently. The high current i goes through the switches 120 above-described.

A high current coupled with a high frequency leads to a high electromagnetic field generated by said switches 120. But, as said switches 120 are encased within said cage 100, the electromagnetic compatibility, referred as EMC, requirements are achieved.

### • Other electronic printed card 15

As illustrated in Fig. 2 and Fig. 6, in a non-limitative embodiment, the electronic device 1 further comprises another electronic printed card 15 located inside said housing 11 and comprising the video sensor 150 of said light receiver 17. In a non-limitative embodiment, said video sensor 150 is a TOF sensor. The video sensor 150 transforms the reflected light signal received from the lens 170 of the light receiver 17 into electrical signals which form a matrix of pixels also called an image.

Said video sensor 150 is further coupled with a processor unit 151 disposed on said other electronic printed card 15. Said processor unit 151 is adapted to analyze the electrical signals, that is to say the matrix of pixels, coming from the video sensor 150 and to compute the distance between said light receiver 17 and an object in the scene.

In a non-limitative embodiment, said other electronic printed card 15 is disposed at the bottom 130a of said receptacle 13. In a non-limitative embodiment, the other electronic printed card 15 is screwed and glued with a thermal paste at the bottom 130a of said receptacle 13.

In a non-limitative embodiment said video sensor 150 is disposed on a face of said other electronic printed card 15 which is facing the intermediate frame 14.

### • Heatsink 16

As illustrated in Fig. 2 and Fig. 6, in a non-limitative embodiment, said electronic device 1 further comprises a heatsink 16 which is adapted to dissipate the heat generated by the processor unit 151 used to compute the distance. In a non-limitative embodiment, the heatsink 16 is in contact with the receptacle 13 and is disposed all along said receptacle 13.

It is to be understood that the present invention is not limited to the aforementioned embodiments and variations and modifications may be made without departing from the scope of the invention. In the respect, the following remarks are made.

It is to be understood that the present invention is not limited to the aforementioned application.
Hence, in another non-limitative embodiment, the electronic device 1 may be used within a Smartphone, a TV, a video game, en elevator, a metro, a train etc.

It is to be understood that the present invention is not limited to the aforementioned embodiments.
Hence, in another non-limitative embodiment, the electronic printed card 12 is not sandwiched between said cover 10 and said receptacle 13, but is fixed on said intermediate frame 14. In a non-limitative embodiment, said electronic card 12 is screwed or glued on said intermediate frame 14. Hence, in another non-limitative embodiment, the intermediate frame 14 is not sandwiched between said electronic printed card 12 and said receptacle 13, but is fixed on said other electronic printed card 15.
It is to be understood that the schematic diagram which illustrate the components of the electronic device 1 does not represented the real scale of said components.

Hence, in another non-limitative embodiment, the heatsink 16 is formed by the receptacle 13 itself.

Hence, in another embodiment, the active electronic device is a diode, a digital or analog circuit etc.

Hence, some embodiments of the invention may comprise one or a plurality of the following advantages:
- it permits to fulfill the EMC requirements while using a high frequency and a high current i ;
- it permits to shield the electronic component(s) 120 which emits an electromagnetic radiation W to as to lower the level of the magnetic field generated by the electronic device 1;
- thanks to the opposite current directions, it permits to have a much more localized electromagnetic radiation W than a dipole;
- thanks to the cage 100 which is integrally forms with the upper cover 10 so as to form a monobloc unit, it permits to obtain a more integrated electronic device solution than one with a detachable cage;
- thanks to the monobloc unit, it permits to have a more economic electronic device solution as it reduces the number of components for the assembly of the electronic device 1;
- it permits to use a unique fixing means 4 for fixing almost all the elements of the electronic device 1 together: the cover 10, the electronic printed card 12, the receptacle 13 and furthermore the intermediate frame 14;
- it permits to have a cage 100 easy to manufacture;
- it permits to configure the length of the walls 100a according to the space available between the structural piece 10, 13, 14 and the electronic printed card 12, contrary to a detachable cage available in the market.

Any reference sign in the following claims should not be construed as limiting the claim. It will be obvious that the verb "to comprise" and its conjugations do not exclude the presence of any other steps or components beside those defined in any claim. The word "a" or "an" preceding an component or step does not exclude the presence of a plurality of such components or steps.

## Claims

1. Electronic device (1) comprising at least one electrically conductive structural piece (10, 13, 14) and an electronic printed card (12) with at least one electronic component (120) emitting an electromagnetic radiation (W), wherein said at least one structural piece (10, 13, 14) comprises walls (100a) forming a cage (100) located inside the external periphery (100b, 130b, 140b) of said at least one structural piece (10, 13, 14), said walls (100a) extending towards said electronic printed card (12) and said cage (100) being adapted to be positioned over said at least one electronic component (120), said cage (100) forming a one-piece with said at least one structural piece (10, 13, 14).

2. Electronic device (1) according to claim 1, wherein said at least one structural piece (10, 13, 14) is a cover (10) and/or a receptacle (13) of a housing (11) of said electronic device (1) and/or an intermediate frame (14) of said electronic device (1).

3. Electronic device (1) according to claim 2, wherein said electronic printed card (12) is sandwiched between said cover (10) and said receptacle (13).

4. Electronic device (1) according to any of the preceding claims 1 to 3, wherein said cage (100) is molded with said at least one structural piece (10) or is stamped within said at least one structural piece (10, 13,14).

5. Electronic device (1) according to any of the preceding claims 1 to 4, wherein said at least one electronic component (120) is an active electronic component.

6. Electronic device (1) according to any of the preceding claims 1 to 5, wherein said electronic printed card (12) comprises a ground trace (121), and wherein said ground trace (121) is adapted to surround said at least one electronic component (120).

7. Electronic device (1) according to any of the preceding claims 1 to 6, wherein said electronic printed card (12) comprises a ground trace (121), and wherein free ends of walls (100a) of said structural piece (10, 13, 14) comprise at least one contact surface (101) with said ground trace (121).

8. Electronic device (1) according to any of the preceding claims 1 to 7, wherein said electronic printed card (12) comprises a plurality of electronic components (120) which are arranged on said electronic printed card (12) so as to limit the current path (Pth).

9. Electronic device (1) according to claim 8, wherein said plurality of electronic components (120) are arranged on said electronic printed card (12) so as to create opposite current directions (D(i)).

10. Electronic device (1) according to any of the preceding claims 1 to 9, wherein said electronic device (1) further comprises a light transmitter (122) comprising at least one light source (123), and a light receiver (17).

11. Electronic device (1) according to claim 2 and claim 10, wherein said intermediate frame (14) is adapted to support a lens (170) of said light receiver (17).

12. Electronic device (1) according to claim 10, wherein said at least one structural piece (10, 13, 14) further comprises an opening (103, 124, 142) through which a lens (170) of said light receiver (17) is adapted to be inserted.

13. Electronic device (1) according to claim 2, wherein said intermediate frame (14) is sandwiched between said electronic printed card (12) and said receptacle (13).

14. Electronic device (1) according to any of the preceding claims 1 to 13, wherein said electronic device (1) further comprises another electronic printed card (15) comprising a video sensor (150).

15. Electronic device (1) according to claim 2 and claim 14, wherein said other electronic printed card (15) is disposed at the bottom (130a) of said receptacle (13).

16. Electronic device (1) according to any of the preceding claims 1 to 15, wherein said electronic device (1) is a TOF camera.
